(19) Europäisches Patentamt

European Patent Office

Office européen des brevets

(11) **EP 1 086 003 B1**

(12) **EUROPÄISCHE PATENTSCHRIFT**

(45) Veröffentlichungstag und Bekanntmachung des Hinweises auf die Patenterteilung:
**13.10.2004 Patentblatt 2004/42**

(21) Anmeldenummer: **00929339.0**

(22) Anmeldetag: **06.04.2000**

(51) Int Cl.$^7$: **B60R 21/01**, H03G 7/08

(86) Internationale Anmeldenummer:
**PCT/EP2000/003052**

(87) Internationale Veröffentlichungsnummer:
**WO 2000/063046 (26.10.2000 Gazette 2000/43)**

(54) **SCHALTUNGSANORDNUNG ZUM MESSEN VON VERZÖGERUNGEN EINES FAHRZEUGS, VERURSACHT DURCH EINEN VOR EINEM CRASH ERFOLGTEN BREMSVORGANG**

CIRCUIT ARRANGEMENT FOR MEASURING THE DECELERATION OF A VEHICLE, CAUSED BY A PRE-CRASH BRAKING PROCEDURE

CIRCUIT POUR LA MESURE DE DECELERATION D'UN VEHICULE RESULTANT D'UN PROCESSUS DE FREINAGE S'ETANT DEROULE AVANT UN IMPACT

(84) Benannte Vertragsstaaten:
**DE FR GB IT SE**

(30) Priorität: **15.04.1999 DE 19916954**

(43) Veröffentlichungstag der Anmeldung:
**28.03.2001 Patentblatt 2001/13**

(60) Teilanmeldung:
**04003956.2 / 1 419 938**

(73) Patentinhaber: **ROBERT BOSCH GMBH**
**70442 Stuttgart (DE)**

(72) Erfinder:
• **MATTES, Bernhard**
  **D-74343 Sachsenheim (DE)**
• **MEHLER, Gerhard**
  **F-14970 Bénouville (FR)**

(56) Entgegenhaltungen:
**EP-A- 0 402 027        US-A- 5 083 276**

## Beschreibung

Stand der Technik

Die vorliegende Erfindung betrifft eine Schaltungsanordnung zum Messen von Verzögerungen eines Fahrzeugs, die, verursacht durch einen vor einem Crash erfolgten Bremsvorgang, zu einer Sitzpositionsveränderung der Fahrzeuginsassen führen, wobei ein Analog-Digital-Umsetzer die analoge Ausgangsspannung eines Beschleunigungssensors für eine nachfolgende Signalauswertung in ein digitales Messignal umsetzt.

Aus EP 402 027 A1 (Oberbegriff von Anspruch 1) ist ein Verfahren und eine Vorrichtung zur Bereitstellung eines Signals für die Aktorik eines Rückhaltesystems bekannt. Es wird mit einem Beschleunigungssensor die Energie bestimmt und einem Schwellwertvergleich zugeführt, um zu entscheiden, ob ein gewaltsamer Crash vorliegt. Dabei wird ein Thermokonverter verwendet, der von einer steuerbaren Stromquelle mit dem Heizstrom versorgt wird. Aus US 5,083,276 A ist eine Anordnung zur Steuerung eines Rückhaltesystems bekannt, wobei Beschleunigungssensoren jeweils ein Messverstärker nachgeschaltet ist.

Aus dem Tagungsband des 3rd International Symposium on Sophisticated Car Occupant Safety Systems, Airbag 2000, 1996, November 26/27, Karlsruhe, Seite 16-1 bis 15-20 ist es bekannt, mittels sogenannter Precrash-Sensoren, mit denen auf der Basis von Radar oder Infrarotstrahlung oder Ultraschall der Abstand bzw. die Relativgeschwindigkeit des Fahrzeugs gegenüber einem Hindernis ermittelt werden kann, eine Vorhersage zu treffen, ob ein Crash des Fahrzeugs mit einem Hindernis bevorsteht. Außerdem ist in dieser Druckschrift ein Innenraumsensor beschrieben, der mit

Infrarotstrahlung und Ultraschall die Position eines Fahrzeuginsassen auf seinem Sitz erfaßt. In Abhängigkeit von der Position des Fahrzeuginsassen wird die Auslösung, d.h. die Aufblasstärke, eines Airbags so gesteuert, daß der Insasse bei einem Fahrzeugcrash einen optimalen Schutz erfährt. Befindet sich der Fahrzeuginsasse in einer sog. Out-Of-Position Lage, in der die Auslösung eines Airbags für den Insassen eher gefährlich werden könnte, wird der Airbag deaktiviert.

Erfahrungsgemäß leitet der Fahrer eines Fahrzeugs, bevor es zu einem tatsächlichen Crash kommt, einen Bremsvorgang ein. Dieser auch als Precrash-Braking bezeichnete Bremsvorgang führt dazu, daß vor allem ein Insasse auf dem Beifahrersitz in Richtung auf den Beifahrer-Airbag vorverlagert wird. Aus der Verzögerung, die das Fahrzeug durch solch einen Bremsvorgang vor einem Crash erfährt, kann in Zusammenarbeit mit dem Innenraumsensor rechtzeitig vor dem eintretenden Crash die Positionsverlagerung des Insassen erfaßt werden, so daß dementsprechend eine Aktivierung bzw. auch Deaktivierung des Airbags eingeleitet werden kann.

Der Erfindung liegt nun die Aufgabe zugrunde, eine Schaltungsanordnung zum Messen von Verzögerungen eines Fahrzeugs, die - verursacht durch einen vor einem Crash erfolgten Bremsvorgang - zu einer Sitzpositionsveränderung von Fahrzeuginsassen führen, anzugeben, die mit möglichst einfachen Schaltungsmitteln realisierbar ist.

Vorteile der Erfindung

Die genannte Aufgabe wird mit den Merkmalen des Anspruchs 1 gelöst. Dabei wird das Ausgangssignal eines Beschleunigungssensors, nachdem es von einem Analog-Digital-Umsetzer in ein digitales Meßsignal umgesetzt worden ist, ausgewertet . Als Beschleunigungssensor wird ein für die Erfassung von hohen, bei einem Crash auftretenden Verzögerungen ausgelegter Sensor verwendet. Ein Verstärker ist vorgesehen, der die auf niedrige Verzögerungen zurückgehende Ausgangsspannung des Sensors verstärkt, so daß das aus der verstärken Ausgangsspannung vom Analog-Digital-Umsetzer abgeleitete digitale Meßsignal eine hinreichend hohe Auflösung der Verzögerungen aufweist.

Gemäß der Erfindung wird also für die Erfassung eines vor einem Crash erfolgenden Bremsvorganges ein sowieso im Fahrzeug vorhandener Beschleunigungssensor verwendet, der eigentlich für die Messung von hohen bei einem tatsächlichen Crash auftretenden Beschleunigungen in Fahrzeuglängsrichtung bis zum 35-fachen der Erdbeschleunigung g bestimmt ist. Die Erfindung ermöglicht es, daß ein an sich für die Messung von sehr hohen Beschleunigungen vorgesehener Sensor auch für die Erfassung von niedrigen Verzögerungen (0,1 g bis 1 g) wie sie bei Precrash-Bremsvorgängen vorkommen, ausgenutzt wird, wobei das Meßsignal für die niedrigen Verzögerungen eine ausreichend hohe Auflösung aufweist.

Vorteilhafte Weiterbildungen der Erfindung gehen aus den Unteransprüchen hervor. So können an den Verstärker Schaltungsmittel angeschlossen sein, die den Hub der Verstärker-Ausgangsspannung auf den vom Analog-Digital-Umsetzer konvertierbaren Spannungsbereich beschränken bzw. umsetzten. Der Verstärker kann z.B. ein Operationsverstärker sein, an dessen Ausgang ein Transistor in Kollektorschaltung angeschlossen ist, der den Hub der Ausgangsspannung des Operationsverstärkers auf den vom Analog-Digital-Umsetzer konvertierbaren Spannungsbereich nach oben beschränkt und nach unten bis nahe an das Massepotential erweitert. Es kann dabei ein kostengünstiger bipolarer Operationsverstärker eingesetzt werden, der relativ hohe Ausgangssättigungsspannungen besitzt, um trotzdem eine hohe Auflösung des Beschleunigungsmeßsignals zu erreichen.

Beschreibung eines Ausführungsbeispiels

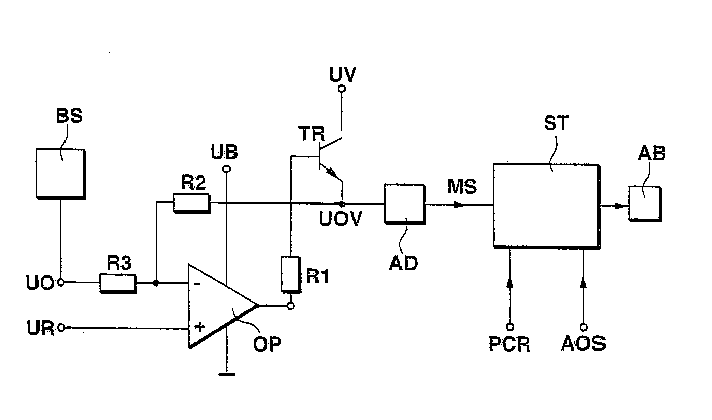

Anhand eines in der Zeichnung dargestellten Ausführungsbeispiels wird nachfolgend die Erfindung näher erläutert.

In der einzigen Figur der Zeichnung ist eine Schaltungsanordnung dargestellt, mit der Verzögerungen eines Fahrzeugs gemessen werden können, die, verursacht durch einen vor einem Crash des Fahrzeugs erfolgten Bremsvorgang, zu einer Sitzpositionsveränderung der Fahrzeuginsassen führen. Die Schaltungsanordnung mißt die Verzögerung des Fahrzeugs, und eine Steuereinheit ST, welche für die Aktivierung eines oder mehrerer Airbags AB und anderer Rückhalteeinrichtungen zuständig ist, wertet das gemessene Verzögerungssignal MS zusammen mit einer Precrash-Information PCR und der Information AOS eines Innenraumsensor aus. Kommt von einem Precrash-Sensor eine Information PCR über einen bevorstehenden Crash oder erkennt der Fahrer ein nahendes Hindernis, so ist eine danach gemessene Verzögerung MS des Fahrzeugs mit großer Wahrscheinlichkeit auf einen Bremsvorgang zurückzuführen, den der Fahrer angesichts des bevorstehenden Crashes eingeleitet hat. Diese Verzögerung führt zu einer Verlagerung der Insassen aus ihrer idealen Position heraus, so daß die Steuereinheit ST dementsprechend eine für den Schutz der Fahrzeuginsassen geeignete Ansteuerung von Rückhaltemitteln veranlaßt. Je nach der von einem Innenraumsensor erfaßten Lage AOS der Fahrzeuginsassen können Airbags mehr oder weniger stark oder in Stufen aufgeblasen werden, oder es kann eine Airbagauslösung unterbunden werden, falls die betreffende Person eine Vorverlagerung zu dicht an den Airbag heran erfahren hat.

Zur Erfassung der Fahrzeugverzögerung bei einem Bremsvorgang vor einem Crash (Precrash-Braking) wird mindestens ein Beschleunigungssensor BS verwendet, der an sich dafür vorgesehen ist, die beim Crash auftretenden Fahrzeugverzögerungen bzw. Beschleunigungen in Fahrzeuglängsrichtung zu messen. Dieser Beschleunigungssensor BS muß in der Lage sein, sehr hohe Beschleunigungen bis zu 35 g (g = Erdbeschleunigung), wie sie in Crash-Situationen auftreten, zu erfassen. Obgleich bei einem Precrash-Braking erheblich geringere Verzögerungen, nämlich von 0,1 g bis 1 g, auftreten als bei einem tatsächlichen Crash, wird der für die Erfassung hoher Beschleunigungswerte ausgelegte Beschleunigungssensor BS verwendet. Ein Beschleunigungssensor BS der für die Messung von Verzögerungen bis zu 35 g ausgelegt ist, besitzt z.B. eine Meßempfindlichkeit von 55 mV/g. Wird zur Umsetzung der analogen Ausgangsspannung des Beschleunigungssensors in ein digitales von der Steuereinheit ST zu verarbeitendes Meßsignal einem 8 Bit-Analog-Digital-Umsetzer zugeführt, so ergibt sich für das Meßsignal eine Auflösung von ca. 0,36 g/Bit. Diese Auflösung des Meßsignals ist für die Erfassung von niedrigen Verzögerungen zwischen 0,1 g und 1 g erheblich zu gering. Um trotzdem eine bessere Meßsignalauflösung mit einem 8-Bit Analog-Digital-Umsetzer AD zu erreichen, ist ein Operationsverstärker OP vorgesehen, an dessen einem Eingang die Ausgangsspannung UO des Beschleunigungssensor BS und an dessen anderem Eingang eine Referenzspannung UR angelegt wird. Durch die Verstärkung des Ausgangssignals UO, dessen Meßempfindlichkeit z.B. bei 55 m/Vg liegt, um beispielsweise

$$\text{den Faktor 10} = \left| \frac{R2}{R3} \right|$$

entsteht eine Beschleunigungsmeßspannung UOV die mit dem anschließenden 8 Bit-Analog-Digital-Umsetzer in ein digitales Messignal MS mit genügend hoher Auflösung umgesetzt werden kann.

Die dem Analog-Digital-Umsetzer AD zugeführte Spannung UOV sollte mit seinem Hub innerhalb des von dem Analog-Digital-Umsetzer AD verarbeitbaren Spannungsbereichs liegen und auf keinen Fall die maximal mögliche Eingangsspannung des Analog-Digital-Umsetzers über- oder unterschreiten, da sonst der Analog-Digital-Umsetzer alle anliegenden Spannungswerte UOV falsch konvertieren würde. Verwendet man einen preisgünstigen bipolaren Operationsverstärker, ist nicht unbedingt gewährleistet, daß sein Ausgangsspannungshub den zulässigen Eingangspannungshub des Analog-Digital-Umsetzers nicht überschreitet. Es gibt preisgünstige Operationsverstärker (zum Beispiel der LM2904), die zum Beispiel einen Ausgangsspannungshub von Massepotential + 1,5 V bis zur Versorgungsspannung UB - 2 V geht. Bei einer Versorgungsspannung UB des Operationsverstärkers von 8 Volt erreicht also der Ausgangsspannungshub eine obere Grenze von 6 V. Geht aber der Eingangsspannungshub des Analog-Digital-Umsetzers AD nur bis 5 V, so würde der Wandlungsbereich des Analog-Digital-Umsetzers AD von der Ausgangsspannung des Operationsverstärkers OP überschritten. Um das zu vermeiden, ist an den Ausgang des Operationsverstärkers OP ein Transistor TR in Kollektorschaltung angeschlossen. Dieser Transistor TR, dessen Vorspannung UV = 5 V beträgt, bewirkt eine Hubbegrenzung der Ausgangsspannung des Operationsverstärkers OP durch eine Basis-Kollektor-Diodenklammerung auf 5 V, so daß die am Emitter des Transistors TR liegende Eingangsspannung UOV des Analog-Digital-Umsetzers den oberen Wert 5 V des Wandlungsbereichs nicht überschreitet. Der Ausgang des Operationsverstärkers OP ist über einen Widerstand R1 an die Basis des Transistors TR gelegt, und der Emitter des Transistors TR ist über einen Gegenkopplungs-Widerstand R2 mit demjenigen Eingang des Operationsverstärkers OP verbunden, an dem die Ausgangsspannung UO des Beschleunigungssensors BS liegt.

Der 0 g-Offset des Beschleunigungssensors BS und des nachfolgenden Verstärkers OP bleibt bei der Ermittlung des Meßsignals MS unbeachtet und wird erst im Steuergerät ST bei der Bildung von Auslösekriterien berücksichtigt.

**Patentansprüche**

1.  Schaltungsanordnung zum Messen von Verzögerungen eines Fahrzeugs, die, verursacht durch einen vor einem Crash erfolgten Bremsvorgang, zu einer Sitzpositionsveränderung der Fahrzeuginsassen führen, wobei ein Analog-Digital-Umsetzer (AD) die analoge Ausgangsspannung eines Beschleunigungssensors (BS) für eine nachfolgende Signalauswertung in ein digitales Mess-Signal (MS) umsetzt, wobei der Beschleunigungssensor (BS) für die Erfassung von hohen, bei einem Crash auftretenden Verzögerungen ausgelegt ist, wobei die Schaltungsanordnung mit einer Steuereinheit (ST) zur Ansteuerung von Rückhaltemitteln (AR) verbunden ist, **dadurch gekennzeichnet, dass** ein Verstärker (OP) vorgesehen ist, der eine zu geringe Ausgangsspannung des Sensors (BS), die von einer niedrigen Verzögerung des Bremsvorgangs herrührt, verstärkt, so dass das aus der verstärkten Ausgangsspannung (UOV) vom Analog-Digital-Umsetzer (AD) abgeleitete digitale Mess-Signal (MS) eine hinreichend hohe Auflösung der Verzögerungen aufweist, und daß die Steuereinheit (ST) in Abhängigkeit von einer Precrash Information (PCR), einem Signal (DOS) des Innenraumsensors und des Meßsignals (MS) die Rückhaltemittel ansteuert.

2.  Schaltungsanordnung nach Anspruch 1, **dadurch gekennzeichnet, dass** an den Verstärker (OP) Schaltungsmittel (TR) angeschlossen sind, die den Hub der Verstärker-Ausgangsspannung an den vom Analog-Digital-Umsetzer (AD) konvertierbaren Spannungsbereich anpassen.

3.  Schaltungsanordnung nach einem der Ansprüche 1 oder 2, **dadurch gekennzeichnet, dass** der Verstärker ein Operationsverstärker (OP) ist und dass an den Ausgang des Operationsverstärkers (OP) ein Transistor (TR) in Kollektorschaltung angeschlossen ist, der den Hub der Ausgangsspannung des Operationsverstärkers (OP) auf den vom Analog-Digital-Umsetzer (AD) konvertierbaren Spannungsbereich beschränkt.

**Claims**

1.  Circuit arrangement for measuring decelerations of a vehicle which are caused by a braking operation which has taken place before a crash and which bring about a change in the sitting position of the vehicle occupants, an analogue/digital converter (AD) converting the analogue output voltage of an acceleration sensor (BS) for a subsequent signal evaluation into a digital measurement signal (MS), the acceleration sensor (BS) being configured to sense large decelerations occurring in the event of a crash, the circuit arrangement being connected to a control unit (ST) for actuating restraint means (AR), **characterized in that** an amplifier (OP) is provided which amplifies an excessively low output voltage of the sensor (BS), which is due to a small deceleration of the braking operation, so that the digital measurement signal (MS) which is derived from the amplified output voltage (UOV) of the analogue/digital converter (AD) has a sufficiently high resolution of the decelerations, and **in that** the control unit (ST) actuates the restraint means as a function of precrash information (PC) a signal (DOS) of the passenger compartment sensor and of the measurement signal (MS).

2.  Circuit arrangement according to Claim 1, **characterized in that** circuit means (TR) which adapt the excursion of the amplifier output voltage to the voltage range which can be converted by the analogue/digital converter (AD) are connected to the amplifier (OP).

3.  Circuit arrangement according to one of Claims 1 or 2, **characterized in that** the amplifier is an operational amplifier (OP), and **in that** a transistor (TR) in collector connection is connected to the output of the operational amplifier (OP) and restricts the excursion of the output voltage of the operational amplifier (OP) to the voltage range which can be converted by the analogue/digital converter (AD).

**Revendications**

1.  Circuit pour la mesure des décélérations d'un véhicule qui, résultant d'un processus de freinage avant un impact, conduisent à un changement de position d'assise des occupants du véhicule, dans lequel un convertisseur analogique-numérique (AD) convertit en un signal de mesure (MS) numérique la tension de sortie analogique d'un capteur d'accélérations (BS) pour exploiter ultérieurement le signal, le capteur d'accélérations (BS) étant prévu pour détecter des décélérations élevées survenant en cas d'impact, et
le circuit est relié à une unité de commande (ST) pour commander des moyens de retenue (AR), **caractérisé en ce qu'**
un amplificateur (OP) amplifie une tension de sortie du capteur (BS) trop faible provenant d'une faible décélération du processus de freinage, de telle sorte que le signal de mesure (MS) numérique obtenu par le convertisseur analogique-numérique (AD) suite à la tension de sortie amplifiée (UOV) présente une résolution des décélérations suffisamment élevée, et
l'unité de commande (ST) commande les moyens de retenue en fonction d'une information de pré-impact (PC), d'un signal (DOS) du capteur intérieur et du signal de mesure (MS).

2. Circuit selon la revendication 1,
**caractérisé en ce que**
des moyens de couplage (TR) sont connectés à l'amplificateur (OP) pour adapter la course de la tension de sortie de l'amplificateur à la plage de tension convertissable par le convertisseur analogique-numérique (AD).

3. Circuit selon l'une des revendications 1 ou 2,
**caractérisé en ce que**
l'amplificateur est un amplificateur opérationnel (OP), et un transistor (TR) est connecté à la sortie de l'amplificateur opérationnel (OP) dans le circuit collecteur et limite la course de la tension de sortie de l'amplificateur opérationnel (OP) dans la plage de tension convertissable par le convertisseur analogique-numérique (AD).